# EUROPÄISCHE PATENTSCHRIFT

(11) **EP 2 827 693 B1**
(45) Veröffentlichungstag und Bekanntmachung des Hinweises auf die Patenterteilung: **02.09.2020**
(21) Anmeldenummer: 14176499.3
(22) Anmeldetag: 10.07.2014
(51) Int. Cl.: H05K 13/02

(54) **Lagervorrichtung zur Lagerung von elektronischen Bauelementen**
Storage device for storing electronic components
Dispositif de stockage de composants électroniques

(30) Priorität: 17.07.2013 DE 102013011891
(43) Veröffentlichungstag der Anmeldung: 21.01.2015
(73) Patentinhaber: Seger GmbH, 66709 Weiskirchen (DE); Totech Europe BV, 8013 RP Zwolle (NL)
(72) Erfinder: Seger, Andreas, 66709 Weiskirchen (DE); Kurpiela, Gerhard, 74363 Güglingen (DE)
(74) Vertreter: Isfort, Olaf

(56) Entgegenhaltungen:
- EP-A2- 0 959 653
- WO-A1-2005/034601
- DE-U1-202004 006 920
- JP-A- H07 183 690
- KR-A- 20120 139 263

## Beschreibung

Die Erfindung betrifft eine Lagervorrichtung zur Lagerung von elektronischen Bauelementen, mit einem Gehäuse, in dem Gehäuse befindlichen Lagerplätzen zur Ablage der Bauelemente, einer Handhabungsvorrichtung zur Handhabung der Bauelemente, wobei die Handhabungsvorrichtung die Bauelemente bei der Einlagerung auf den Bauelementen zugewiesenen Lagerplätzen ablegt und bei der Auslagerung von den Lagerplätzen wieder aufnimmt, und einem Steuerrechner, der die Handhabungsvorrichtung ansteuert.

Die JP H07 182690 A betrifft eine Lagervorrichtung für elektronische Bauteile mit einem Entfeuchter.

Die EP 0 959 653 A2 betrifft eine Lagereinrichtung zum Bereithalten elektronischer Bauelemente mit einem gasdichten Gehäuse und mit einer Entfeuchtungseinrichtung zum Aufrechterhalten einer vorgegebenen Gasatmosphäre.

Die WO 2005/034601 A1 offenbart einen Spezialtrockenschrank mit einem Trockenraum zur Trockenlagerung feuchtigkeitsempfindlicher elektronischer Bauteile, wobei der Trockenraum eine Feederbank zur Aufnahme von einem oder mehreren Feedern aufweist.

Die KR 2012 0139263 A beschreibt eine Speichervorrichtung mit einem Gehäuse, das einen Stauraum beinhaltet, mit einer Vielzahl von Magazinen, die im Gehäuse so angeordnet sind, dass sie voneinander unterscheidbar sind, mit vertikalen Führungen und horizontalen Führungen, die vertikal beweglich entlang der vertikalen Führungen installiert sind, und einer Lesevorrichtung, die im Lufteinlass und -auslass installiert ist.

Bei der Herstellung von Elektronikbauteilen und -schaltungen werden Bestückungsautomaten verwendet, die beispielsweise Platinen mit elektronischen Bauelementen bestücken. Die Bauelemente, bei denen es sich meist um SMD-Bauelemente handelt, befinden sich üblicherweise auf Spulen, die auch als "Reels" bezeichnet werden, oder auf Ablageschalen, die auch als "Trays" bezeichnet werden. Die Spulen oder Ablageschalen werden in die Bestückungsautomaten eingesetzt. Von den Spulen bzw. aus den Ablageschalen werden die elektronischen Bauelemente einzelnen den Bestückungsautomaten zugeführt.

Die herzustellenden Elektronikbauteile bzw. -schaltungen wechseln häufig. Entsprechend müssen den Bestückungsautomaten unterschiedliche Bauelemente zur Bestückung zugeführt werden. D.h., dass die Bestückungsautomaten durch Einsetzen jeweils anderer Spulen bzw. Ablageschalen umgerüstet werden müssen. Daher ist es in den Herstellungsbetrieben von Elektronikbauteilen und -schaltungen erforderlich, eine Vielzahl unterschiedlicher Spulen bzw. Ablageschalen verwechslungsfrei und leicht zugänglich zu lagern.

Bekannt ist es, die Spulen bzw. Ablageschalen in entsprechend ausgelegten Regalen, Magazinen oder sonstigen Lagerungsmöbeln abzulegen. Dort werden sie, beispielsweise nach Nummern sortiert, vom Bedienungspersonal der Bestückungsautomaten ein- und ausgelagert. Solche manuellen Systeme sind langsam, die verwendeten Lagerregale, Magazine usw. beanspruchen viel Platz. Die manuelle Lagerung ist außerdem fehleranfällig.

Um diese Nachteile zu beseitigen, schlägt die DE 20 2004 006 920 U1 ein Lagersystem vor, das eine schnelle und verwechslungsfreie ein- und Auslagerung von elektronischen Bauelementen ermöglicht. Es handelt sich dabei um einen Lagerautomaten, d.h. eine Lagervorrichtung mit einer rechnergesteuerten Handhabungsvorrichtung zur Handhabung der elektronischen Bauelemente, wobei die Handhabungsvorrichtung die Bauelemente bei der Einlagerung auf den Bauelementen zugewiesenen Lagerplätzen ablegt und bei der Auslagerung von den Lagerplätzen wieder aufnimmt. Der Steuerrechner des bekannten Lagersystems steuert die Handhabungsvorrichtung an und verwaltet die den elektronischen Bauelementen zugeordneten Lagerplätze in einer Datenbank. Die einzulagernden Bauelemente werden identifiziert, wobei der Steuerrechner den Bauelementen jeweils einen freien Lagerplatz nach dem Prinzip der dynamischen Lagerplatzzuordnung zuordnet.

Ein Problem ist, dass viele elektronische Bauelemente, wie beispielsweise Widerstände, Kondensatoren, Dioden, Transistoren oder integrierte Schaltungen, aufgrund ihres Aufbaus und der verwendeten Materialien hygroskopisch sind, so dass die Bauelemente Feuchtigkeit aus der Umgebungsluft aufnehmen. Die Feuchtigkeit in den Bauelementen führt zu Qualitätsproblemen. Die Feuchtigkeit wirkt sich negativ bei der Herstellung von elektronischen Schaltungen aus, da die Feuchtigkeit beim Lötvorgang verdampft und zu Beschädigungen der Bauelemente führt. Die Feuchtigkeit führt darüber hinaus zu Funktionsbeeinträchtigungen der hergestellten Schaltungen und Elektronikbauteile.

Um die elektronischen Bauelemente vor Feuchtigkeit zu schützen, werden sie herstellerseitig in Folienverpackungen verschweißt, meist unter Beifügung von Trockenmittel (zum Beispiel Silikagel). Dieser Schutz entfällt jedoch, nachdem die Folienverpackung angebrochen ist. Während der Lagerung nehmen die elektronischen Bauelemente Feuchtigkeit auf und haben daher nur eine sehr begrenzte Lebensdauer. Die elektronischen Bauelemente, die nach dem Anbruch der Folienverpackung ihre maximale Lebensdauer erreicht haben, sind nicht mehr verwendbar und müssen teuer und umweltschädlich entsorgt werden.

Vor diesem Hintergrund ist es Aufgabe der Erfindung, eine Lagervorrichtung für elektronische Bauelemente bereitzustellen, die ein langfristiges Lagern von hygroskopischen Bauelementen in Herstellungsbetrieben von Elektronikbauteilen und elektronischen Schaltungen ermöglicht.

Diese Aufgabe löst die Erfindung ausgehend von einer Lagervorrichtung der eingangs angegebenen Art dadurch, dassdie Lagerplätze jeweils einer von wenigstens zwei Lagerzonen zugeordnet sind, wobei sich die Lagerzonen hinsichtlich der Feuchtigkeit der Atmosphäre und/oder der Temperatur in der jeweiligen Lagerzone unterscheiden, wobei die erste Lagerzone durch ein erstes Schubladenmodul gebildet ist, während die zweite Lagerzone durch ein zweites Schubladenmodul gebildet ist, wobei sich die Lagerplätze der zweiten Lagerzone in einem inneren Gehäuse befinden, das sich innerhalb des äußeren Gehäuses der Lagervorrichtung befindet, wobei die Atmosphäre innerhalb der zweiten Lagerzone gegenüber der entfeuchteten Atmosphäre der ersten Lagerzone abgeschirmt ist.

Kerngedanke der Erfindung ist, die Gasatmosphäre im Inneren der Lagervorrichtung zu entfeuchten, so dass vermieden wird, dass die gelagerten elektronischen Bauelemente während der Lagerung Feuchtigkeit ziehen. Die Entfeuchtung der Atmosphäre in der Lagervorrichtung ist mit geringem technischem Aufwand möglich. Geeignete Entfeuchter, die der im Gehäuse der Lagervorrichtung befindlichen Luft die Feuchtigkeit entziehen, sind kommerziell zu vergleichsweise geringen Kosten erhältlich. Es eignen sich beispielsweise Adsorptionstrockner oder auch Kondensationstrockner. Die Kosten des dadurch entstehenden apparativen Aufwands werden dadurch überkompensiert, dass die elektronischen Bauelemente praktisch unbegrenzt gelagert werden können und daher nicht - wie bisher - nach Erreichen ihrer (geringen) maximalen Lagerungsdauer an Umgebungsluft entsorgt werden müssen.

Vorteilhaft ist weiterhin, dass die Entfeuchtung der Atmosphäre in der erfindungsgemäßen Lagervorrichtung so erfolgen kann, dass die Feuchtigkeit, die von den elektronischen Bauelementen bereits aufgenommen wurde, an die entfeuchtete Atmosphäre im Gehäuse wieder abgegeben wird, sobald die Bauelemente in der erfindungsgemäßen Lagervorrichtung gelagert werden. Die elektronischen Bauelemente ziehen Feuchtigkeit, während sie sich in den Bestückungsautomaten, das heißt außerhalb der Lagervorrichtung befinden. Diese Feuchtigkeit kann den elektronischen Bauelementen in der erfindungsgemäßen Lagervorrichtung wieder entzogen werden. Dadurch verlängert sich die Dauer der Benutzbarkeit der elektronischen Bauelemente weiter. Die aus dem Stand der Technik bekannten Qualitätsprobleme werden beseitigt.

Bei einer bevorzugten Ausgestaltung der erfindungsgemäßen Lagervorrichtung sind mit dem Steuerrechner verbundene Mittel zur Identifizierung der Bauelemente vorgesehen, wobei der Steuerrechner den Bauelementen bei der Einlagerung jeweils einen freien Lagerplatz nach dem Prinzip der dynamischen Lagerplatzzuordnung zuordnet. Als Mittel zur Identifizierung kommt beispielsweise ein Barcodeleser oder auch ein RFID-Lesegerät infrage. Die dynamische Lagerplatzzuordnung ermöglicht eine optimale Ausnutzung des zur Verfügung stehenden Lagervolumens. Die erfindungsgemäße Lagervorrichtung kommt, anders ausgedrückt, mit deutlich weniger Platz aus als die herkömmlichen manuellen Systeme.

Besonders bevorzugt befinden sich die Lagerplätze der erfindungsgemäßen Lagervorrichtung auf Auszügen eines Schubladenlagers. Die Auszüge bilden gleichsam die Schubladen des Schubladenlagers, auf denen die elektronischen Bauelemente in mehreren Ebenen übereinander gelagert werden. Die Spulen bzw. Ablageschalen, auf denen sich die elektronischen Bauelemente üblicherweise befinden, haben eine geringe Höhe. Daher eignet sich ein Schubladenlager besonders gut, um eine große Zahl von elektronischen Bauelementen übereinander zu lagern. Die Höhe der einzelnen Schubladen kann entsprechend gering ausfallen. Ein Schubladenlager ermöglicht also eine besonders Platz sparende Lagerung. Die Schubladen des Schubladenlagers können automatisiert bewegt, das heißt ausgezogen und eingeschoben werden. Dies kann mittels der Handhabungsvorrichtung der erfindungsgemäßen Lagervorrichtung erfolgen oder auf andere geeignete Weise, d.h. z.B. mittels einer eigens hierfür vorgesehenen Vorrichtung, die ebenfalls von dem Steuerrechner angesteuert wird.

Weiter bevorzugt ist der Entfeuchter der erfindungsgemäßen Lagervorrichtung Bestandteil einer Klimaanlage, die Temperatur und/oder Feuchtigkeit der Atmosphäre im Gehäuse steuert oder regelt. Die Aufnahme und Abgabe von Feuchtigkeit hängt nicht nur von der relativen Feuchtigkeit der Atmosphäre ab, sondern auch von der Temperatur, bei der die elektronischen Bauelemente gelagert werden. Bei einer erhöhten Temperatur geben die elektronischen Bauelemente in erhöhtem Maße Feuchtigkeit ab. Eine geeignete Klimatechnik, zur Regelung oder Steuerung von Temperatur und Feuchtigkeit ist für die erfindungsgemäße Lagervorrichtung problemlos am Markt verfügbar.

Bevorzugt sollte das Gehäuse der erfindungsgemäßen Lagervorrichtung im Wesentlichen gasdicht und/oder thermisch isolierend sein. Ein gasdichtes und thermisch isolierendes Gehäuse hat den Vorteil, dass die Entfeuchtung und die Regelung der Temperatur im Gehäuseinneren effizient erfolgen können. Eine vollständige Gasdichtheit ist jedoch nicht erforderlich, selbst bei gewissen Leckraten kann eine geeignete Feuchtigkeit der Atmosphäre im Inneren des Gehäuses problemlos hergestellt werden. Gleiches gilt für die Regelung der Temperatur. Eine thermische Isolierung hat jedoch den Vorteil, dass Energiekosten gespart werden. Außerdem wird eine unerwünschte Aufheizung der Umgebung der erfindungsgemäßen Lagervorrichtung vermieden.

Besonders vorteilhaft ist die Ausgestaltung der erfindungsgemäßen Lagervorrichtung, bei der die Lagerplätze jeweils einer von wenigstens zwei Lagerzonen zugeordnet sind, wobei sich die Lagerzonen hinsichtlich der Feuchtigkeit der Atmosphäre und/oder der Temperatur in der jeweiligen Lagerzone unterscheiden. Diese Ausgestaltung basiert auf der Erkenntnis, dass an die Feuchtigkeit der Atmosphäre und an die Lagertemperatur zur langfristigen Lagerung der elektronischen Bauelemente geringere Anforderungen zu stellen sind als an die Feuchtigkeit und Temperatur, wenn zusätzlich bereits in den elektronischen Bauelementen vorhandene Feuchtigkeit aus diesen wieder entfernt werden soll, wenn also die elektronischen Bauelemente rückgetrocknet werden sollen, um die maximale Benutzungs- und Lagerdauer wieder herzustellen. Anders ausgedrückt müssen die elektronischen Bauelemente bei höherer Temperatur und geringerer Feuchtigkeit gelagert werden, um die Rücktrocknung zu bewirken. Zum dauerhaften Lagern genügt eine geringere Temperatur bei höherer Feuchtigkeit. Zur Lagerung über längere Zeiträume ist die geringere Temperatur sogar vorteilhaft, da die elektronischen Bauelemente bei niedriger Temperatur verlangsamt altern. Die Ausgestaltung der erfindungsgemäßen Lagervorrichtung mit unterschiedlichen Lagerzonen erhöht also die Effizienz, da nur diejenigen elektronischen Bauelemente, die tatsächlich rückzutrocknen sind, in der dafür vorgesehenen Lagerzone gelagert werden, während die übrigen elektronischen Bauelemente bei den weniger aufwändig und energieintensiv herzustellenden Lagerbedingungen gelagert werden können. Die Unterteilung in Lagerzonen hat den Vorteil, dass die zur Rücktrocknung vorgesehene Lagerzone kleiner dimensioniert werden kann. Dies spart Herstellungs- und Energiekosten.

In einer ersten Lagerzone der erfindungsgemäßen Lagervorrichtung sollte die Temperatur wenigstens 10 °C (vorteilhaft für die Langzeitlagerung über mehrere Jahre), vorzugsweise wenigstens 40 °C betragen, wobei die relative Feuchtigkeit weniger als 10 %, möglichst sogar weniger als 5 % betragen sollte. Diese Bedingungen genügen, um die elektronischen Bauelemente dauerhaft zu lagern, das heißt ohne dass diese weiter Feuchtigkeit ziehen. Zur Rücktrocknung der elektronischen Bauelemente, d.h. zum Entfernen von in den elektronischen Bauelementen bereits vorhandener Feuchtigkeit, genügen diese Bedingungen allerdings in der Regel nicht.

Daher sollte in einer zweiten Lagerzone der erfindungsgemäßen Lagervorrichtung die Temperatur wenigstens 40 °C, vorzugsweise wenigstens 60 °C betragen, während die relative Feuchtigkeit weniger als 5 %, vorzugsweise weniger als 0,5 % beträgt. Bei diesen Bedingungen werden die elektronischen Bauelemente, die bereits Feuchtigkeit gezogen haben, wirksam rückgetrocknet, so dass deren maximale Lagerungs- und Nutzungsdauer wieder hergestellt wird.

Bei der erfindungsgemäßen Ausgestaltung der Lagervorrichtung befinden sich die Lagerplätze der zweiten Lagerzone in einem inneren Gehäuse, das sich innerhalb des äußeren Gehäuses der Lagervorrichtung befindet. Dabei ist zweckmäßig das innere Gehäuse im Wesentlichen gasdicht und thermisch isolierend. Die Anordnung des inneren Gehäuses in dem äußeren Gehäuse der Lagervorrichtung hat den Vorteil, dass die Atmosphäre innerhalb der zweiten Lagerzone nur gegenüber der ohnehin bereits entfeuchteten Atmosphäre der ersten Lagerzone abgeschirmt sein muss. Ebenso muss die zweite Lagerzone nur gegenüber der ersten Lagerzone, die sich ohnehin bereits auf einem erhöhten Temperaturniveau befindet, temperiert werden. Diese Maßnahmen erhöhen die Effizienz der erfindungsgemäßen Lagervorrichtung hinsichtlich Entfeuchtung und Temperierung. Da die Handhabungsvorrichtung der Lagervorrichtung Zugriff auf die Lagerplätze der ersten und zweiten Lagerzone haben muss, weist das innere Gehäuse zweckmäßig eine verschließbare Öffnung auf, durch die die Bauelemente auf Lagerplätzen der zweiten Lagerzone mittels der Handhabungsvorrichtung einlagerbar und von dort wieder auslagerbar sind. Bei dieser Ausgestaltung kann die Handhabungsvorrichtung gleichermaßen auf die Lagerplätze der ersten Lagerzone und auf die Lagerplätze der zweiten Lagerzone zugreifen. Um die unterschiedlichen Bedingungen in den beiden Lagerzonen aufrechterhalten zu können, ist die Öffnung des inneren Gehäuses in geeigneter Weise verschließbar, beispielsweise mittels einer elektromotorisch bewegbaren Tür oder Klappe.

Bei einer weiter bevorzugten Ausgestaltung der erfindungsgemäßen Lagervorrichtung ist der Steuerrechner eingerichtet, die Bauelemente zwischen den Lagerzonen umzulagern. Dies ermöglicht es, diejenigen Bauelemente, die einer Rücktrocknung bedürfen, zeitweise in der für die Rücktrocknung vorgesehenen Lagerzone zu lagern. In dieser Lagerzone verbleiben die Bauelemente so lange wie es erforderlich ist, um die in den Bauelementen vorhandene Feuchtigkeit hinreichend zu reduzieren. Nach erfolgter Rücktrocknung werden die Bauelemente aus der für die Rücktrocknung vorgesehenen Lagerzone in die für die langfristige Lagerung vorgesehene Lagerzone umgelagert. Dort können die Bauelemente dann bis auf weiteres verbleiben. Ebenso kann die für die langfristige Lagerung vorgesehene Lagerzone als Puffer dienen, wo die Bauelemente verbleiben können, z.B. bis in der für die Rücktrocknung vorgesehenen Lagerzone ein Lagerplatz frei wird. Durch intelligente Programmierung des Steuerrechners kann erreicht werden, dass im Laufe der Zeit sämtliche der umgeschlagenen Bauelemente optimal getrocknet und langfristig lagerbar sind.

Wie oben erwähnt, sind die Bauelemente bevorzugt SMD-Bauelemente, die sich jeweils auf einer Spule ("Reel") oder auf eine Ablageschale ("Tray") befinden, wobei die Handhabungsvorrichtung eine Greifvorrichtung aufweist, die zum Greifen der Spule bzw. der Ablageschale ausgebildet ist. Ebenso können sich die zu lagernden Bauelemente in Schachteln (Kartons) befinden.

Bei einer weiter bevorzugten Ausgestaltung der erfindungsgemäßen Lagervorrichtung weist das äußere Gehäuse eine Öffnung zum Eingeben von einzelnen Spulen, Ablageschalen oder Schachteln auf. Das Bedienungspersonal braucht nichts weiter zu tun als die zu lagernden Spulen bzw. Ablageschalen oder Schachteln in die Öffnung der Lagervorrichtung einzugeben. Innerhalb der Lagervorrichtung erfolgen dann eine Identifizierung, eine automatische Lagerplatzzuweisung nach dem Prinzip der dynamischen Lagerplatzzuordnung, wie oben beschrieben, und die automatische Handhabung der Spulen, Ablageschalen bzw. Schachteln bei der Einlagerung und Umlagerung. Das Bedienungspersonal kann eine Spule, Ablageschale oder Schachtel über den Steuerrechner der Lagervorrichtung anfordern. Diese wird dann automatisch ausgelagert und ausgegeben, so dass sie vom Bedienungspersonal entgegengenommen und dann ein Bestückungsautomat damit ausgerüstet werden kann.

Vorzugsweise weist die erfindungsgemäße Lagervorrichtung einen Einlagerungsförderer auf, der eine Mehrzahl von einzulagernden Spulen, Ablageschalen oder Schachteln aufnimmt, wobei der Einlagerungsförderer die Spulen, Ablageschalen oder Schachteln von der Öffnung in den Zugriffsbereich der Handhabungsvorrichtung fördert. Der Einlagerungsförderer fungiert gleichsam als Puffer, der es ermöglicht, eine Mehrzahl von Spulen, Ablageschalen oder Schachteln gleichzeitig in die Lagervorrichtung einzugeben, ohne dass das Bedienungspersonal abwarten muss bis jede einzelne Spule, Ablageschale oder Schachtel eingelagert wurde, bevor die nächste Spule, Ablageschale oder Schachtel eingegeben werden kann. Der Einlagerungsförderer bewirkt also eine Entkopplung der Tätigkeit des Bedienungspersonals bei der Eingabe von dem Betrieb der Handhabungsvorrichtung bei der Einlagerung.

Ein Ausführungsbeispiel der Erfindung wird im Folgenden anhand der Zeichnung näher erläutert. Es zeigt:

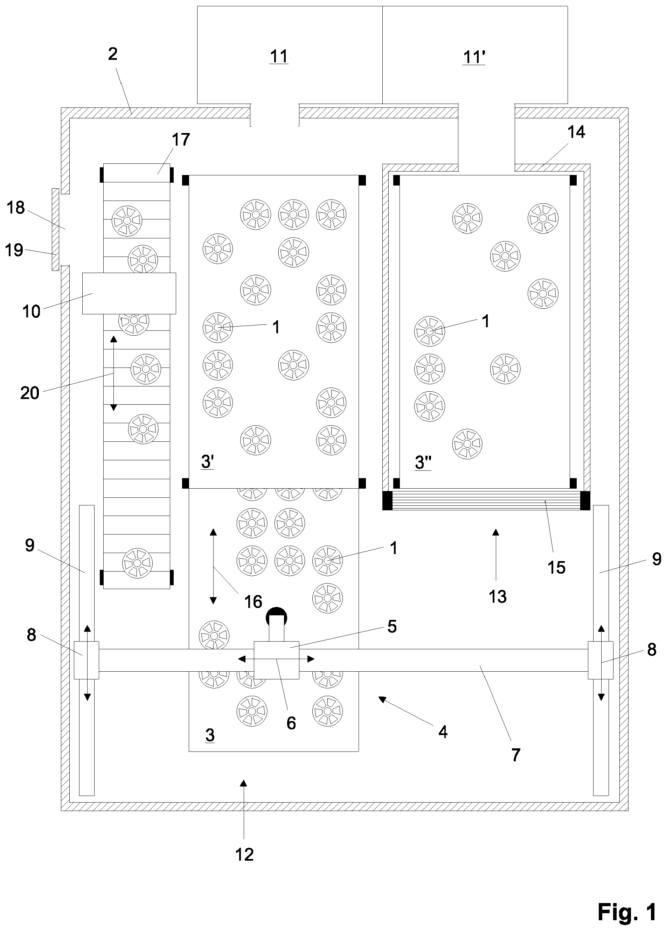

- Figur 1:: eine erfindungsgemäße Lagervorrichtung in teilweise geschnittener Ansicht von oben.

Die in der Figur 1 schematisch dargestellte Lagervorrichtung dient zur Lagerung von SMD-Bauelementen, die sich auf Spulen 1 befinden. Die Lagervorrichtung weist ein äußeres Gehäuse 2 auf. In dem Gehäuse 2 befinden sich Lagerplätze zur Ablage der Spulen 1. Die Lagerplätze befinden sich auf Auszügen 3, 3', 3" eines Schubladenlagers. Innerhalb des Gehäuses 2 befindet sich weiterhin eine Handhabungsvorrichtung 4 mit einem Greiforgan 5, das eingerichtet ist, die Spulen 1 von oben her zu greifen, so dass die Handhabungsvorrichtung 4 die Spulen 1 aufnehmen, transportieren und ablegen kann. Das Greiforgan 5 ist, wie durch den Doppelpfeil 6 angedeutet, entlang einer ersten Schiene 7 seitlich verfahrbar. Die erste Schiene 7 ist, wie durch die Doppelpfeile 8 angedeutet, entlang zweiter Schienen 9 vor und zurück verfahrbar. Zusätzlich ist das Greiforgan 5 auf und ab beweglich, d.h. senkrecht zur Darstellungsebene der Figur 1 (nicht dargestellt). Insgesamt ist das Greiforgan 5 also in allen drei Raumrichtungen beweglich. Die Handhabungsvorrichtung 4 wird von einem Steuerrechner (nicht dargestellt) angesteuert. Der Steuerrechner ist mit Mitteln zur Identifizierung der Spulen 1, beispielsweise anhand von Barcodes, verbunden. Der Barcodeleser ist in der Figur 1 mit der Bezugsziffer 10 bezeichnet. Nach Identifizierung der Spulen 1 weist der Steuerrechner diesen bei der Einlagerung jeweils einen freien Lagerplatz nach dem Prinzip der dynamischen Lagerplatzzuordnung zu. Die Handhabungsvorrichtung 4 ergreift die Spulen 1 und legt diese auf den Auszügen 3, 3', 3" entsprechend dem vom Steuerrechner jeweils zugeordneten Lagerplatz ab. Die Lagervorrichtung weist des Weiteren eine Klimaanlage 11 auf, deren Bestandteil ein Entfeuchter ist, der die Atmosphäre im Gehäuse 2 entfeuchtet. Die Klimaanlage 11 regelt die Temperatur und die Feuchtigkeit der Atmosphäre im Gehäuse 2. Um effizient bestimmte Atmosphärenbedingungen im Inneren des Gehäuses 2 mittels der Klimaanlage 11 erzeugen zu können, ist das Gehäuse 2 thermisch isolierend und im Wesentlichen gasdicht.

Bei dem in der Figur 1 dargestellten Ausführungsbeispiel sind die Lagerplätze jeweils einer von zwei Lagerzonen zugeordnet. Die erste Lagerzone wird durch das in der Figur 1 mit der Bezugsziffer 12 bezeichnete Schubladenmodul gebildet, während die zweite Lagerzone durch das mit der Bezugsziffer 13 bezeichnete Schubladenmodul gebildet wird. Die Schubladenmodule 12 und 13 sind bei dem dargestellten Ausführungsbeispiel nebeneinander angeordnet. Jede andere Art der Anordnung ist denkbar. Insbesondere können die Lagerzonen auch durch vertikal übereinander angeordnete Bereiche eines Schubladenmoduls gebildet sein. Die beiden Lagerzonen unterscheiden sich bei dem Ausführungsbeispiel hinsichtlich der Feuchtigkeit der Atmosphäre und/oder der Temperatur in der jeweiligen Lagerzone. Das Schubladenmodul 12 ist gegenüber dem Inneren des Gehäuses 2 offen ausgestaltet. Somit entspricht die Atmosphäre in der ersten Lagerzone hinsichtlich Temperatur und Feuchtigkeit der Atmosphäre im Inneren des Gehäuses 2. Das Schubladenmodul 13 weist ein inneres Gehäuse 14 auf, das ebenfalls gasdicht und thermisch isolierend ist. Das Gehäuse 14 schottet das Innere des Schubladenmoduls 13 vom Inneren des Gehäuses 2 ab. Die mittels einer weiteren Klimaanlage 11' erzeugte Atmosphäre im Inneren des Gehäuses 14 unterscheidet sich von der Atmosphäre im Inneren des Gehäuses 2. In der ersten Lagerzone beträgt die Temperatur 10-40 °C, während die relative Feuchtigkeit weniger als 5 % beträgt. Diese Bedingungen reichen aus, um die auf den Spulen 1 befindlichen elektronischen Bauelemente langfristig zu lagern, das heißt ohne dass diese Feuchtigkeit aufnehmen. Im Inneren des Gehäuses 14 beträgt die Temperatur wenigstens 40-60 °C, während die relative Feuchtigkeit weniger als 5 % beträgt. Bei diesen Bedingungen geben die auf den Spulen 1 befindlichen elektronischen Bauelemente Feuchtigkeit ab, die die Bauelemente bereits aufgenommen haben. D.h., dass die Bauelemente in der zweiten Lagerzone rückgetrocknet werden. An seiner Vorderseite weist das Schubladenmodul 13 eine automatisch verschließbare Öffnung auf. Zum Öffnen und Verschließen dient ein elektromotorisch betätigtes Rolltor 15. Zum Zugriff auf die in dem Schubladenmodul 13 gelagerten Spulen 1 wird das Rolltor 15 geöffnet. Daraufhin wird einer der Auszüge des Schubladenmoduls 13 automatisch nach vorne herausgezogen, so dass die auf dem Auszug befindlichen Spulen 1 in den Zugriffsbereich der Handhabungsvorrichtung 4 gelangen. Nach Ablage oder Aufnahme einer Spule 1 wird der Auszug wieder eingefahren und das Rolltor 15 verschlossen, um so die Bedingungen hinsichtlich Feuchtigkeit und Temperatur in der zweiten Lagerzone dauerhaft aufrechterhalten zu können. Der Steuerrechner der Lagervorrichtung ist eingerichtet, die Spulen 1 zwischen den beiden Lagerzonen, d.h. zwischen den beiden Schubladenmodulen 12 und 13 umzulagern. Hierzu nimmt die Handhabungsvorrichtung 4 zum Beispiel eine Spule 1 von dem Auszug 3 auf, daraufhin wird der Auszug 3, wie durch den Doppelpfeil 16 angedeutet, eingefahren. Ein Auszug des Schubladenmoduls 13 wird, nach Öffnung des Rolltors 15, ausgefahren und die aufgenommene Spule 1 wird auf diesem Auszug abgelegt. Danach wird der Auszug des Schubladenmoduls 13 wieder eingefahren und das Rolltor 15 wird geschlossen. Entsprechend umgekehrt wird beim Umlagern aus dem Schubladenmodul 13 in das Schubladenmodul 12 vorgegangen.

Wie weiter in der Figur 1 dargestellt ist, weist die Lagervorrichtung einen Einlagerungsförderer 17 auf. Bei diesem handelt es sich um einen Endlosförderer üblicher Bauart. Das äußere Gehäuse 2 weist eine Öffnung 18 auf, die mittels einer Klappe 19 thermisch isolierend und weitgehend gasdicht verschlossen werden kann. Die Öffnung 18 dient zum Eingeben von einzelnen Spulen 1 in die Lagervorrichtung. Die Spulen 1 werden auf dem Einlagerungsförderer 17 abgelegt. Der Einlagerungsförderer 17 fördert die Spulen, wie durch den Doppelpfeil 20 angedeutet, in den Zugriffsbereich der Handhabungsvorrichtung 4, so dass die Handhabungsvorrichtung 4 die Spulen 1 von dem Einlagerungsförderer 17 übernehmen und in einem der Schubladenmodule 12 oder 13 ablegen kann. Ebenso kann der Einlagerungsförderer 17 dazu dienen, die Spulen 1 beim Auslagern zur Öffnung 18 zu verbringen, von wo sie das Bedienungspersonal übernehmen kann. Alternativ kann eine separate Ausgabeöffnung vorgesehen sein, die bei der Auslagerung der Spulen 1 benutzt wird (nicht dargestellt).

## Patentansprüche

1. Lagervorrichtung zur Lagerung von elektronischen Bauelementen, mit einem Gehäuse (2), in dem Gehäuse (2) befindlichen Lagerplätzen zur Ablage der Bauelemente, einer Handhabungsvorrichtung (4) zur Handhabung der Bauelemente, wobei die Handhabungsvorrichtung (4) die Bauelemente bei der Einlagerung auf den Bauelementen zugewiesenen Lagerplätzen ablegt und bei der Auslagerung von den Lagerplätzen wieder aufnimmt, und einem Steuerrechner, der die Handhabungsvorrichtung (4) ansteuert, wobei die Lagervorrichtung wenigstens einen Entfeuchter aufweist, der die Atmosphäre im Gehäuse (2) entfeuchtet,
**dadurch gekennzeichnet,**
**dass** die Lagerplätze jeweils einer von wenigstens zwei Lagerzonen zugeordnet sind, wobei sich die Lagerzonen hinsichtlich der Feuchtigkeit der Atmosphäre und/oder der Temperatur in der jeweiligen Lagerzone unterscheiden, wobei die erste Lagerzone durch ein erstes Schubladenmodul (12) gebildet ist, während die zweite Lagerzone durch ein zweites Schubladenmodul (13) gebildet ist, wobei sich die Lagerplätze der zweiten Lagerzone in einem inneren Gehäuse (14) befinden, das sich innerhalb des äußeren Gehäuses (2) der Lagervorrichtung befindet, wobei die Atmosphäre innerhalb der zweiten Lagerzone gegenüber der entfeuchteten Atmosphäre der ersten Lagerzone abgeschirmt ist.

2. Lagervorrichtung nach Anspruch 1, **gekennzeichnet durch** mit dem Steuerrechner verbundene Mittel (10) zur Identifizierung der Bauelemente, wobei der Steuerrechner den Bauelementen bei der Einlagerung jeweils einen freien Lagerplatz nach dem Prinzip der dynamischen Lagerplatzzuordnung zuordnet.

3. Lagervorrichtung nach Anspruch 1 oder 2, **dadurch gekennzeichnet, dass** sich die Lagerplätze auf Auszügen eines Schubladenlagers (12, 13) befinden.

4. Lagervorrichtung nach einem der Ansprüche 1 bis 3, **dadurch gekennzeichnet, dass** der Entfeuchter Bestandteil einer Klimaanlage (11, 11') ist, die Temperatur und/oder Feuchtigkeit der Atmosphäre im Gehäuse (2) steuert oder regelt.

5. Lagervorrichtung nach einem der Ansprüche 1 bis 4, **dadurch gekennzeichnet, dass** das Gehäuse (2) im Wesentlichen gasdicht und/oder thermisch isolierend ist.

6. Lagervorrichtung nach einem der Ansprüche 1 bis 5, **dadurch gekennzeichnet, dass** in einer ersten Lagerzone die Temperatur wenigstens 10°C, vorzugsweise wenigstens 40°C, und die relative Feuchtigkeit weniger als 10 %, vorzugsweise weniger als 5 % beträgt.

7. Lagervorrichtung nach Anspruch 6, **dadurch gekennzeichnet, dass** in einer zweiten Lagerzone die Temperatur wenigstens 40°C, vorzugsweise wenigstens 60°C, und die relative Feuchtigkeit weniger als 5 %, vorzugsweise weniger als 0,5 % beträgt.

8. Lagervorrichtung nach einem der Ansprüche 1 bis 7, **dadurch gekennzeichnet, dass** das innere Gehäuse (14) im Wesentlichen gasdicht und/oder thermisch isolierend ist.

9. Lagervorrichtung nach einem der Ansprüche 1 bis 8, **dadurch gekennzeichnet, dass** das innere Gehäuse (14) eine verschließbare Öffnung aufweist, durch die die Bauelemente auf Lagerplätzen der zweiten Lagerzone mittels der Handhabungsvorrichtung (4) einlagerbar und von dort wieder auslagerbar sind.

10. Lagervorrichtung nach einem der Ansprüche 1 bis 9, **dadurch gekennzeichnet, dass** der Steuerrechner eingerichtet ist, die Bauelemente zwischen den Lagerzonen umzulagern.

11. Lagervorrichtung nach einem der Ansprüche 1 bis 10, **dadurch gekennzeichnet, dass** die Bauelemente SMD-Bauelemente sind, die sich jeweils auf einer Spule (1), auf einer Ablageschale oder in einer Schachtel befinden, wobei die Handhabungsvorrichtung (4) eine Greifvorrichtung (5) aufweist, die zum Greifen der Spule (1), der Ablageschale oder der Schachtel ausgebildet ist.

12. Lagervorrichtung nach Anspruch 11, **dadurch gekennzeichnet, dass** das äußere Gehäuse (2) eine Öffnung (18) zum Eingeben von einzelnen Spulen (1), Ablageschalen oder Schachteln aufweist.

13. Lagervorrichtung nach Anspruch 12, **gekennzeichnet durch** einen Einlagerungsförderer (17), der eine Mehrzahl von einzulagernden Spulen (1), Ablageschalen oder Schachteln aufnimmt, wobei der Einlagerungsförderer (17) die Spulen, Ablageschalen oder Schachteln von der Öffnung (18) in den Zugriffsbereich der Handhabungsvorrichtung (4) fördert.

## Claims

1. Storage device for storing electronic components, with a housing (2), storage spaces in the housing (2) for storing the components, a handling device (4) for handling the components, wherein the handling device (4) stores the components at the storage spaces allocated to the components on deposition and picks them up again from the storage spaces on retrieval, and a control computer which controls the handling device (4), wherein the storage device comprises at least one dehumidifier which dehumidifies the atmosphere in the housing (2),
**characterised in that**
the storage spaces are each associated with one of at least two storage zones, wherein the storage zones differ in respect of the humidity of the atmosphere and/or the temperature in the respective storage zone, wherein the first storage zone is formed by a first drawer module (12), while the second storage zone is formed by a second drawer module (13), wherein the storage spaces of the second storage zone are located in an inner housing (14), which is located inside the outer housing (2) of the storage device, wherein the atmosphere inside the second storage zone is closed off relative to the dehumidified atmosphere of the first storage zone.

2. Storage device according to claim 1, **characterised by** means (10) connected to the control computer for identifying the components, wherein the control computer allocates a free storage space to the components in each case on deposition according to the principle of dynamic storage space allocation.

3. Storage device according to claim 1 or 2, **characterised in that** the storage spaces are located on pull-outs of a drawer store (12, 13).

4. Storage device according to any one of claims 1 to 3, **characterised in that** the dehumidifier is part of an air-conditioning system (11, 11') which controls or regulates the temperature and/or humidity of the atmosphere in the housing (2).

5. Storage device according to any one of claims 1 to 4, **characterised in that** the housing (2) is substantially gas-tight and/or thermally insulating.

6. Storage device according to any one of claims 1 to 5, **characterised in that** in a first storage zone, the temperature is at least 10°C, preferably at least 40°C, and the relative humidity is less than 10%, preferably less than 5%.

7. Storage device according to claim 6, **characterised in that** in a second storage zone, the temperature is at least 40°C, preferably at least 60°C, and the relative humidity is less than 5%, preferably less than 0.5%.

8. Storage device according to any one of claims 1 to 7, **characterised in that** the inner housing (14) is substantially gas-tight and/or thermally insulating.

9. Storage device according to any one of claims 1 to 8, **characterised in that** the inner housing (14) has a closable opening through which the components can be deposited at storage spaces of the second storage zone and are retrievable from there again by means of the handling device (4).

10. Storage device according to any one of claims 1 to 9, **characterised in that** the control computer is adapted to move the components between the storage zones.

11. Storage device according to any one of claims 1 to 10, **characterised in that** the components are SMD components, which are each located on a reel (1), on a tray or in a carton, wherein the handling device (4) has a gripper device (5), which is designed to grip the reel (1), the tray or the carton.

12. Storage device according to claim 11, **characterised in that** the outer housing (2) has an opening (18) for inserting individual reels (1), trays or cartons.

13. Storage device according to claim 12, **characterised by** a deposition conveyor (17), which receives a plurality of reels (1), trays or cartons to be deposited, wherein the deposition conveyor (17) conveys the reels, trays or cartons from the opening (18) into the access area of the handling device (4).

## Revendications

1. Dispositif de stockage servant au stockage de composants électroniques, avec un boîtier (2), des emplacements de stockage se trouvant dans le boîter (2), servant au rangement des composants, un dispositif de manutention (4) servant à la manutention des composants, dans lequel le dispositif de manutention (4) range les composants lors de l'entreposage sur des emplacements de stockage attribués aux composants et les reprend lors du déstockage hors des emplacements de stockage, et un calculateur de commande, qui pilote le dispositif de manutention (4), dans lequel le dispositif de stockage présente au moins un déshumidificateur, qui déshumidifie l'atmosphère dans le boîtier (2),
**caractérisé en ce que**
les emplacements de stockage sont associés respectivement à une d'au moins deux zones de stockage, dans lequel les zones de stockage se différencient en matière d'humidité de l'atmosphère et/ou de température dans la zone de stockage respective, dans lequel la première zone de stockage est formée par un premier module de tiroir (12), tandis que la deuxième zone de stockage est formée par un deuxième module de tiroir (13), dans lequel les emplacements de stockage de la deuxième zone de stockage se trouvent dans un boîtier intérieur (14), qui se trouve à l'intérieur du boîtier extérieur (2) du dispositif de stockage, dans lequel l'atmosphère à l'intérieur de la deuxième zone de stockage est protégée par rapport à l'atmosphère déshumidifiée de la première zone de stockage.

2. Dispositif de stockage selon la revendication 1, **caractérisé par** des moyens (10) reliés au calculateur de commande, servant à identifier les composants, dans lequel le calculateur de commande associe aux composants lors de l'entreposage respectivement un emplacement de stockage libre selon le principe de l'association d'emplacement de stockage dynamique.

3. Dispositif de stockage selon la revendication 1 ou 2, **caractérisé en ce que** les emplacements de stockage se trouvent sur des rallonges d'un entrepôt à tiroirs (12, 13).

4. Dispositif de stockage selon l'une quelconque des revendications 1 à 3, **caractérisé en ce que** le déshumidificateur fait partie intégrante d'une climatisation (11, 11'), qui commande ou régule la température et/ou l'humidité de l'atmosphère dans le boîtier (2).

5. Dispositif de stockage selon l'une quelconque des revendications 1 à 4, **caractérisé en ce que** le boîtier (2) est sensiblement étanche aux gaz et/ou thermiquement isolant.

6. Dispositif de stockage selon l'une quelconque des revendications 1 à 5, **caractérisé en ce que** dans une première zone de stockage, la température est d'au moins 10 °C, de préférence d'au moins 40 °C et l'humidité relative est inférieure à 10 %, de préférence inférieure à 5 %.

7. Dispositif de stockage selon la revendication 6, **caractérisé en ce que** dans une deuxième zone de stockage, la température est d'au moins 40 °C, de préférence d'au moins 60 °C et l'humidité relative est inférieure à 5 %, de préférence est inférieure à 0,5 %.

8. Dispositif de stockage selon l'une quelconque des revendications 1 à 7, **caractérisé en ce que** le boîtier intérieur (14) est sensiblement étanche aux gaz et/ou thermiquement isolant.

9. Dispositif de stockage selon l'une quelconque des revendications 1 à 8, **caractérisé en ce que** le boîtier intérieur (14) présente une ouverture pouvant être fermée, par laquelle les composants peuvent être entreposés sur des emplacements de stockage de la deuxième zone de stockage au moyen du dispositif de manutention (4) et peuvent en être déstockés à nouveau.

10. Dispositif de stockage selon l'une quelconque des revendications 1 à 9, **caractérisé en ce que** le calculateur de commande est mis au point pour transférer les composants entre les zones de stockage.

11. Dispositif de stockage selon l'une quelconque des revendications 1 à 10, **caractérisé en ce que** les composants sont des composants CMS (composants montés en surface), qui se trouvent respectivement sur une bobine (1), sur un plateau de rangement ou dans une boîte, dans lequel le dispositif de manutention (4) présente un dispositif de préhension (5), qui est réalisé pour saisir la bobine (1), le plateau de rangement ou la boîte.

12. Dispositif de stockage selon la revendication 11, **caractérisé en ce que** le boîtier extérieur (2) présente une ouverture (18) servant à insérer diverses bobines (1), divers plateaux de rangement ou diverses boîtes.

13. Dispositif de stockage selon la revendication 12, **caractérisé par** un convoyeur d'entreposage (17), qui accueille une multitude de bobines (1), de plateaux de rangement ou de boîtes à entreposer, dans lequel le convoyeur d'entreposage (17) convoie les bobines, les plateaux de rangement ou les boîtes depuis l'ouverture (18) dans la zone d'accès du dispositif de manutention (4).
